(19) Europäisches Patentamt
European Patent Office
Office européen des brevets

(11) **EP 1 850 644 A1**

(12) **EUROPEAN PATENT APPLICATION**
published in accordance with Art. 158(3) EPC

(43) Date of publication:
**31.10.2007 Bulletin 2007/44**

(51) Int Cl.:
***H05K 1/18*** *(2006.01)*  ***H05K 3/34*** *(2006.01)*

(21) Application number: **06702531.2**

(22) Date of filing: **06.01.2006**

(86) International application number:
**PCT/JP2006/300317**

(87) International publication number:
**WO 2006/082699 (10.08.2006 Gazette 2006/32)**

(84) Designated Contracting States:
**AT BE BG CH CY CZ DE DK EE ES FI FR GB GR
HU IE IS IT LI LT LU LV MC NL PL PT RO SE SI
SK TR**

(30) Priority: **04.02.2005 JP 2005028995**

(71) Applicant: **Tyco Electronics AMP K.K.
Kawasaki-shi,
Kanagawa 213-8535 (JP)**

(72) Inventor: **TSUJI, Junya
c/o Tyco Electronics AMP K.K.,
Kawasaki-shi, Kanagawa, 213853 (JP)**

(74) Representative: **Johnstone, Douglas Ian et al
Baron & Warren,
19 South End,
Kensington
London W8 5BU (GB)**

(54) **SURFACE MOUNT ELECTRIC PART**

(57)    A surface mounted electric part not requiring any additional facility investment on soldering and free from coming off a substrate even when the substrate is turned over and subjected to reflow. In a state that an electrical part is placed under a circuit board (100), the sum B of the periphery length of a second soldering portion (P2) is so set that the relationship between a downward rotation moment (M1) around a first soldering portion (P1) produced by the gravity and an upward rotation move-ment (M2) acting on a second soldering portion (P2) produced by the surface tension of solder melted during soldering using the overall heating method is M1 ≤ M2, and the sum A of the periphery length of the first soldering portion (P1) is so set that the relationship between a downward rotation movement (M3) around the second soldering portion (P2) produced by the gravity and an upward rotation movement (M4) acting on the first soldering portion (P1) produced by the surface tension is M3 ≤ M4.

FIG.6

**Description**

Technical Field

The present invention relates to a surface mount electrical component which is surface mounted on a circuit board. More specifically, the invention relates to a surface mount electrical component suitable for use a board mounting method in which a surface mount electrical component is surface mounted on one side of a circuit board, then the circuit board is inverted and another surface mount electrical component is soldered on the other side of the circuit board by reflow soldering (overall-heating soldering) with the originally surface mounted electrical component on the underside of the circuit board.

Background Art

Various types of surface mount electrical components are known. It is also generally known that the surface mount electrical components are surface mounted on both sides of a printed circuit board. When the surface mounting is performed on both sides of a printed circuit board, initially (in first soldering), electrical/electronic components to be mounted on one side of the printed circuit board are soldered by reflow soldering, then (in second soldering), the printed circuit board is inverted and other electrical/electronic components are surface mounted again by the reflow soldering. A problem here is that the solder at the portions of the components initially soldered on the printed circuit board are melted during the second reflow soldering, and some of the electrical/electronic components initially attached to the printed circuit board are likely to fall off the circuit board due to their own weights.

As for the solutions to this problem, various methods are attempted. For example, Japanese Unexamined Patent Publication No. 2001-358456 proposes a method in which the environmental temperature of the reflow soldering, i.e. melting range of the solder is changed between the first and second times, so that the solder portions initially soldered and located on the underside of the printed circuit board are not melted.

Another method, in which soldering is performed after electrical/electronic components (packages) are temporarily bonded to the printed circuit board using an adhesive, is also known as described, for example, in Japanese Unexamined Patent Publication No. 10(1998)-256433 (Figure 5). This prevents the packages on the underside of the printed circuit board from falling off when the printed circuit board is inverted and reflow soldering is performed.

Further, in order to prevent a connector on the underside of a printed circuit board, a configuration in which a solder peg is additionally provided as a stabilization compensation member on the side of the connector which is more likely to be separated from the board by the rotational moment is known as described, for example, in Japanese Unexamined Patent Publication No. 2003-115334 (Figure 4). Still further, as a method for enhancing the soldering strength of such a solder peg, it is known that a through hole is created in the solder peg to broaden the area of a solder fillet as described, for example, in Japanese Unexamined Patent Publication No. 10(1998)-064608 (Figure 1).

In the method, in which the solder melting temperature is changed disclosed in Japanese Unexamined Patent Publication No. 2001-358456, however, requires two types of reflow furnaces having different melting temperatures, which poses a problem of high costs for equipment investment and maintenance. Further, the package disclosed in Japanese Unexamined Patent Publication No. 10(1998)-256433, which is temporarily attached to a substrate by applying an adhesive to a protrusion provided on the underside of the package facing the substrate, requires the adhesive, as well as equipment and process (manpower) for applying the adhesive with a dispenser and solidifying the adhesive in a hardening furnace.

As disclosed in Japanese Unexamined Patent Publication Nos. 2003-115334 and 10(1998)-064608, the soldering strength may be increased by adding a solder peg, and creating a hole in the solder peg to increase the area (area or line length) of a solder fillet. But, when the soldered portion of a component is melted by the second reflow soldering, the component is not always securely retained due to the relationship between the surface tension of the soldered portion and rotational moment of the weight of the gravity center. That is, the surface tension required of the soldered portion differs depending on the location of the gravity center, and location and size of the fillet. Accordingly, there may be cases where retaining power of the surface tension is insufficient even a solder peg is additionally provided.

The present invention has been developed in view of the circumstances described above, and it is an object of the present invention to proved a surface mount electrical component which is less likely to fall off a substrate when placed on the underside of the substrate by inverting the substrate and subjected to second reflow in an ordinary soldering process, without requiring investment for additional soldering equipment.

Disclosure of the Invention

The surface mount electrical component of the present invention is a surface mount electrical component including a plurality of soldering portions which is soldered on a surface of a circuit board, wherein:

the total circumferential length of a second soldering portion, on which a solder fillet is formed, of the plurality of soldering portions is set such that, when the surface mount electrical component is on the underside of the circuit board, the relationship between a downward rotational moment M1 around the first soldering portion caused by the gravity force at the gravity center, and an upward rotational moment M2 acting on the second soldering portion produced by the surface tension of melted solder melded during overall-heating soldering is M1 $\leq$ M2; and
the total circumferential length of a first soldering portion, on which a solder fillet is formed, located opposite to the second soldering portion across the gravity center of the surface mount electrical component is set such that, when the surface mount electrical component is on the underside of the circuit board, the relationship between a downward rotational moment M3 around the second soldering portion caused by the gravity force at the gravity center and an upward rotational moment M4 acting on the first soldering portion produced by the surface tension of melted solder melded during the overall-heating soldering is M3 $\leq$ M4.

Note that the surface mount electrical component includes electronic components, such as semiconductor chips, packages having an outer lead and the like, as well as electrical components such as electrical connectors and the like.

The referent of "overall-heating soldering" as used herein means a concept against "partial-heating soldering" using a soldering iron, pulse heater, hot air, or flow, and includes reflow soldering.

The total circumferential lengths A and B of the first and second soldering portions may take values within the ranges obtained by the following formulae respectively:

$$M1 = L1 \times m, \quad M2 = (L1 + L2) \times Bk$$

$$L1 \times m \leq (L1 + L2) \times Bk$$

$$B \geq (L1 \times m)/(L1 + L2)k$$

$$M3 = L2 \times m, \quad M4 = (L1 + L2) \times Ak$$

$$L2 \times m \leq (L1 + L2) \times Ak$$

$$A \geq (L2 \times m)/(L1 + L2)k$$

(where, L1 is the length from the gravity center to the first soldering portion along the circuit board (mm) ; L2 is the length from the gravity center to the second soldering portion along the circuit board (mm) ; m is the weight of the surface mount electrical component (g); k is a coefficient; A is the total circumferential length of the first soldering portion (mm); and B is the total circumferential length of the second soldering portion (mm)).

Apreferable example of the surface mount electrical component is an electrical connector, in which the first and second soldering portions may be the attachment piece and tine of the electrical contact respectively or vice versa. An opening for increasing a solder fillet forming region may be created in the tine of the electrical contact.

According to the surface mount electrical component of the present invention, the total circumferential length of the second soldering portion is determined such that the relationship between a downward rotational moment M1 around the first soldering portion caused by the gravity force at the gravity center of the surface mount electrical component and an upward rotational moment M2 acting on the second soldering portion caused by surface tension of the melted solder is M1 $\leq$ M2, and the total circumferential length of the first soldering portion is determined such that the relationship between a downward rotational moment M3 around the second soldering portion caused by the gravity force and an upward rotational moment M4 acting on the first soldering portion produced by the surface tension of melted solder is M3 $\leq$ M4. This has the following advantageous effects.

That is, the first and second soldering portions may be designed after calculating required total circumferential lengths, so that a surface mount electrical component which is reliably prevented from falling off a substrate when the substrate is inverted and subjected to soldering. Further, the component may be surface mounted through an ordinary soldering process without requiring investment for additional soldering equipment and maintenance therefor.

When the total circumferential lengths A and B of the first and second soldering portions are set to take values within the ranges obtained by the following formulae respectively:

$$B \geq (L1 \times m)/(L1 + L2)k$$

$$A \geq (L2 \times m)/(L1 + L2)k$$

(where, L1 is the length from the gravity center to the first soldering portion along the circuit board (mm) ; L2 is the length from the gravity center to the second soldering portion along the circuit board (mm) ; m is the weight of the surface mount electrical component (g); k is a coefficient; A is the total circumferential length of the first soldering portion (mm) ; and B is the total circumferential length of the second soldering portion (mm)), a surface mount electrical component free from falling off a substrate may be produced even if the shape of the soldering portions is designed freely within the ranges.

Brief Description of the Drawings

Figure 1A is a front view of a surface mount electrical component according to an embodiment of the present invention, illustrating an overview thereof.

Figure 1B is a plan view of the surface mount electrical component shown in Figure 1A.

Figure 1C is a rear view of the surface mount electrical component shown in Figure 1A.

Figure 2A is a bottom view of the surface mount electrical component shown in Figure 1A.

Figure 2B is a left side view of the surface mount electrical component shown in Figure 1A.

Figure 2C is a right side view of the surface mount electrical component shown in Figure 1A.

Figure 3 is a partially enlarged cross-sectional view taken along the line 3-3 in Figure 1B.

Figure 4 is an enlarged plan view of an electrical contact with a carrier strip.

Figure 5A is a side view of the electrical contact separated from the carrier strip.

Figure 5B is a bottom view of the electrical contact separated from the carrier strip.

Figure 6 is a conceptual diagram, schematically illustrating a state in which a substrate with a surface mount electrical component, surface mounted thereon, is inverted for a second reflow soldering.

Figure 7 is a drawing schematically illustrating a rectangular soldering portion as a specific shape of a fixing portion of a surface mount electrical component.

Figure 8 is a drawing illustrating a soldering portion having another shape.

Best Mode for Carrying Out the Invention

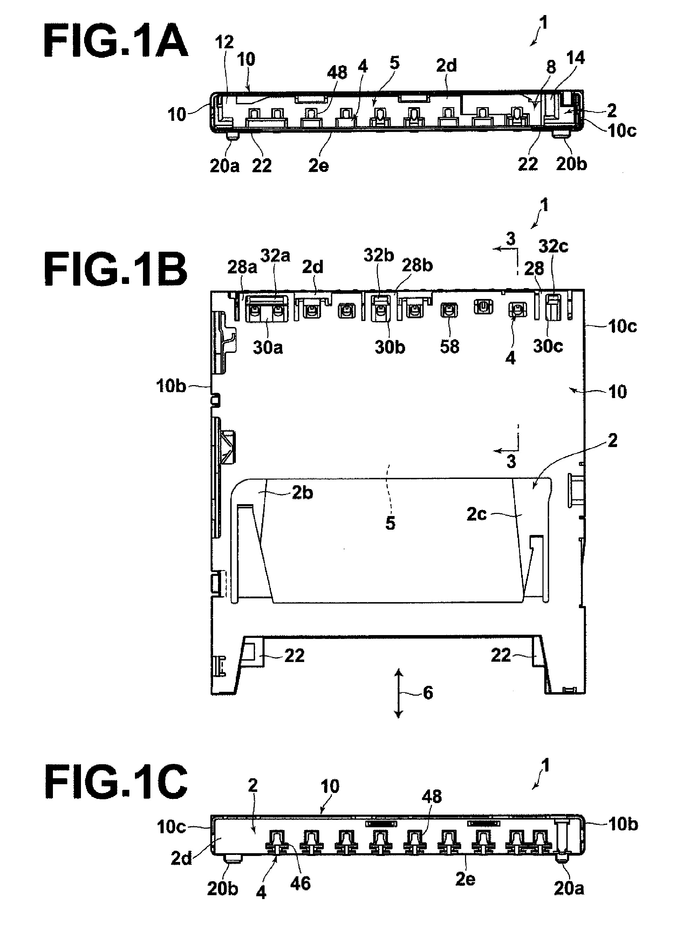

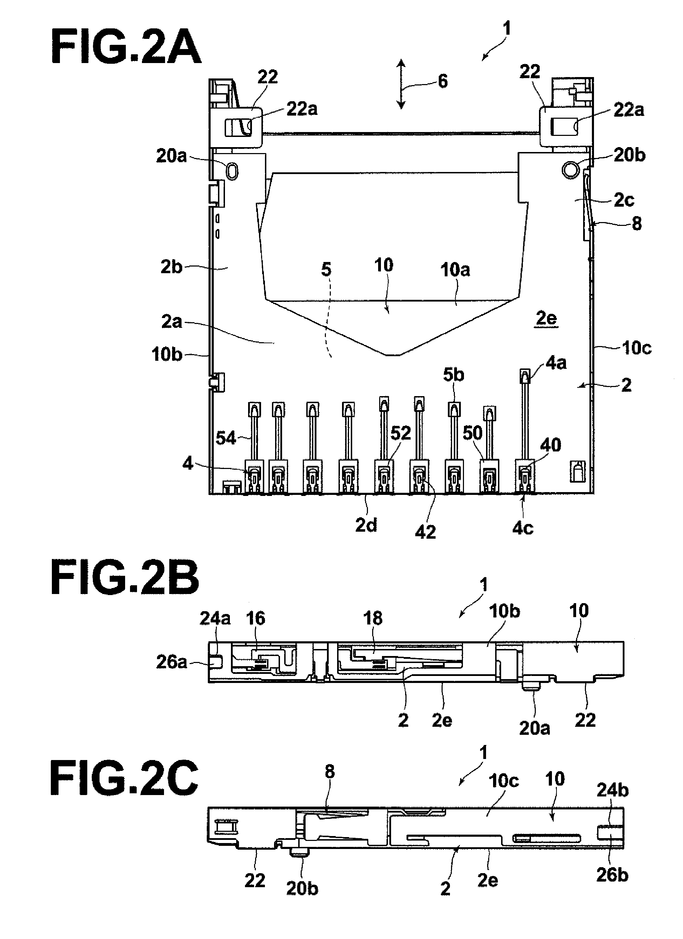

Hereinafter, an exemplary embodiment of a surface mount electrical connector (hereinafter, simply referred to as "connector"), which is an example electrical component of the present invention, will be described with reference to the accompanying drawings. First, an overview of the connector 1 will be described with reference to Figures 1A to 2C. Figures 1A to 1C and Figures 2A to 2C illustrate overviews of the connector 1, in which Figure 1A is a front view, Figure 1B is a plan view, Figure 1C is a rear view, Figure 2A is a bottom view, Figure 2B is a left side view, and Figure 2C is a right side view. In the following description, the referent of "front" means a side from where a card (not shown) is inserted (downside in Figure 1B), and "rear" means a side opposite to the front in the plan view of the connector 1 in Figure 1B. The connector 1 is a card connector and includes a housing 2, contacts 4 held by the housing 2, an ejection mechanism 8, and a metal shell 10 attached to the housing and substantially covers these components. The ejection mechanism 8 is a mechanism that moves along card insertion-removal directions 6 (Figures 1B, 2A) according to insertion/removal of a card.

The housing 2 includes a housing body 2a located in the rear portion thereof, and card guides 2b, 2c extending from the housing body 2a to the front side. The housing body 2a is open on the upper side and includes a rear wall 2d at the rear end. The card guides 2b, 2c include card guide paths 12, 14 respectively on the inner side thereof (Figure 1A). The card guide paths 12, 14 extend to the inside of the housing body 2a. The card guide 2b includes contacts 16, 18 (Figure 2B) for detecting insertion of a card or readiness of the card for write operation, but these are not the subject matter of the present invention and will not be described in detail here. The bottom surface 2e of the housing 2 is substantially flat, but includes positioning bosses 20a and 20b at the front end of the card guide 2b, 2c respectively.

The card guide 2c includes an ejection mechanism 8 which is formed such that when a card is inserted into the connector 1 from the front side and pushed into inside thereof, the card is held at the position, and when the card is pushed again, it is ejected. The ejection mechanism 8 includes a not shown slider which operates by an insertion/ejection operation. The slider is constantly urged by a spring toward the front side of the housing. The ejection mechanism 8 includes a heart-shaped cam groove (not shown) like that as disclosed in Japanese Unexamined Patent Publication No. 2004-207168, and a cam follower (not shown) that moves within the cam groove. This structure is well known in the art, and in addition, it is not the subject matter of the present invention, so that it will not be described in detail here.

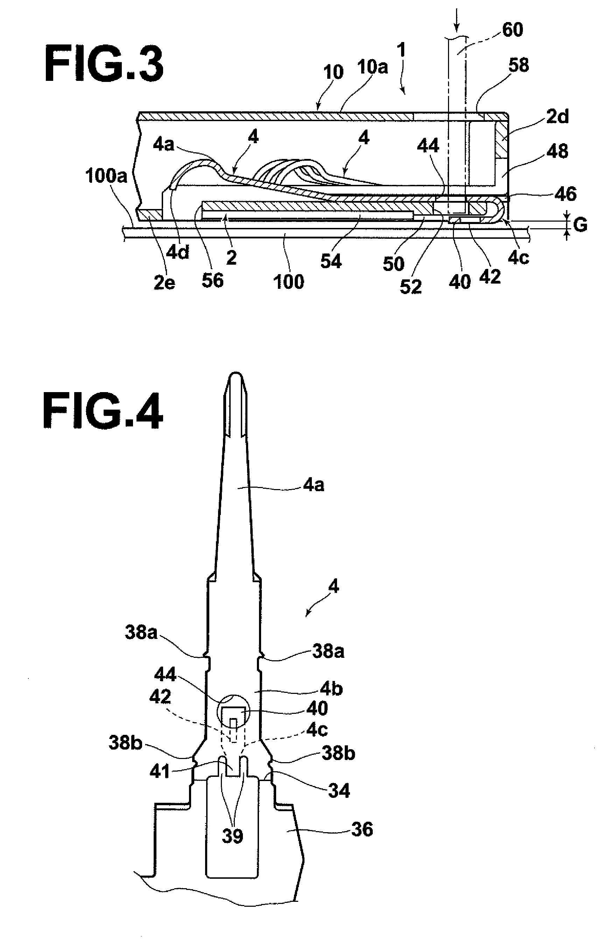

Next, the description will be directed to the shell 10. It is formed of a single metal plate through punching and folding, and includes a principal surface 10a (Figure 1B) that covers the upper side of the housing 2, side walls 10b, 10c folded over the outsides of the card guides 2b, 2c respectively. Protruding rectangular attachment pieces 22 (Figure 2A) are provided at places adjacent to the front end of the respective card guides 2b, 2c, which are folded to the bottom surface of the card guides 2b, 2c. This prevents the shell 10 from moving upward from the housing 2. Each attachment piece 22 includes a rectangular opening 22a in the center and soldered to a circuit board (substrate) 100 (Figure 3). The principal surface of the shell 10 attached to the housing 2 and housing 2 define a card receiving section 5.

As illustrated in Figures 2B, 2C, notches 24a, 24b open to the rear side are provided on the side walls 10b, 10c respectively. In the mean time, protrusions 26a, 26b, each corresponding to each of the notches 24a, 24b, are provided on the side surfaces of the card guides 2b, 2c respectively. Engagement of the notches 24a, 24b with the protrusions 26a, 26b prevents the shell 10 from moving upward and backward of the housing 2. The shell 10 includes, at the rear end portion of the principal surface 10a, lock tongues 28a, 28b, 28c, which are free at the rear end. The lock tongues 28a, 28b, 28c include rectangular lock holes 30a, 30b, 30c respectively. Further, projecting bars 32a, 32b, 32c, each corresponding to each of the lock holes 30a, 30b, 30c, are provided at the rear wall 2d of the housing 2. The engagement of the lock holes 30a, 30b, 30c with the projecting bars 32a, 32b, 32c prevents the shell 10 from moving the front side of the housing 2.

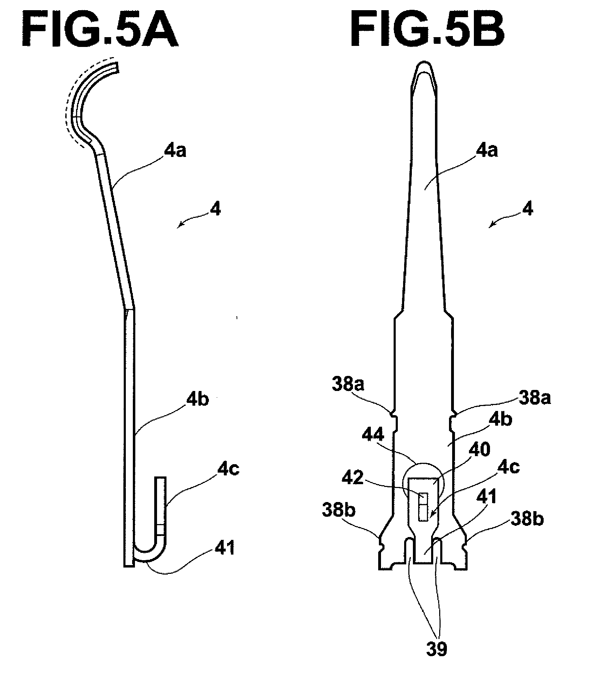

Next, description will be directed to the contact 4 and attachment thereof to the housing 2 with reference also to Figures 3 to 5B. Figure 3 is a partially enlarged cross-sectional view taken along the line 3-3 in Figure 1B. Figure 4 is an enlarged plan view of a contact 4 with a carrier strip. Figure 5A is a side view of the contact 4 separated from the carrier strip, and Figure 5B is a bottom view thereof. First, the contact 4 will be described with reference to Figures 4 to 5B. The contact 4 includes a narrow width contact segment 4a, a wide width held section 4b, and a tine 4c folded back in a U-shape from the held section 4b. A notch or groove 34, V-shaped in cross section and extending in the direction orthogonal to the axis line along the longitudinal direction of the contact 4, is formed at the rear end of the contact 4. The contact 4 is connected to the carrier strip 36 via the groove 34, and separated therefrom by the groove 34.

Lock protrusions 38a, 38b, spaced apart with each other, are formed at each side edge of the held section 4b. When the contact 4 is inserted into a contact insertion groove 46, to be described later, of the housing 2, the lock protrusions 38a, 38b engage with the contact insertion groove 46 and fixed to the housing 2. The contact segment 4a is narrower in width than the held section 4b, biased from the held section 4b, and has an arc shaped tip. Two slots 39, 39, open to the rear side, are formed at the rear end of the contact 4. A narrow width connection section 41 of the tine 4c extends in a U-shape between the slots 39, 39, followed by a wide width soldering portion 40, which is parallel to the held section 4b. The soldering portion 40 includes a rectangular opening 42 in the center. The opening 42, like the opening 22a of the attachment piece 22, increases the soldering strength by increasing the total circumferential length of the soldering portion, as well as increasing the surface tension of the solder when melted. Further, a hole 44 is provided at a position of the held section 4b right above the soldering portion 40. The hole 44 is a passage hole of a jig 60 (Figure 3) for gaining access to the soldering portion 40 of the tine 4c.

Next, the description will be directed to the state in which the contact 4 is attached to the housing 2 with reference to Figures 1A to 3 again. As illustrated in Figure 3, the housing 2 includes a contact insertion groove 46 extending forward along the bottom surface 2e from the rear wall 2d. The contact insertion groove 46 has a width which allows the held section 4b of the contact 4 to be engaged therewith. Further, a contact insertion opening 48 is provided on the rear wall 2d to allow the contact 4 to be inserted through the rear wall 2d. The housing 2 includes a rectangular depression 50 for accommodating the soldering portion 40 of the tine 4c, and a rectangular opening 52 running through the up-down direction is provided at a position within the depression 50 corresponding to the soldering portion 40. The opening 52 of the housing is also communicating with the hole 44 of the contact 4.

The bottom surface 2e of the housing 2 includes a groove 54, V-shaped in cross-section and extending forward from the depression 50 along the card insertion-ejection directions. The groove 54 is provided for reducing thermal stress when the connector 4 is mounted, and formed to the tip of the contact segment 4d and an escape hole 56. The escape hole 56 runs upward through the housing 2 from the bottom surface 2e. The escape hole 56 is provided for the tip 4d of the contact segment 4 not to interfere with the housing 2 by bending toward the housing 2 when a card is inserted. The principal surface 10a of the shell 10 includes an opening 58 formed aligned with the tine 4c, opening 52, and hole 44. When the contact 4 is attached to the housing 2, the tine 4c is located inside of the rear wall 2d, as illustrated in Figure 3. In other words, the tine 4c remains inside of the outer contour line of the housing 2. This is clearly illustrated in Figures 1B and 2A.

The description will now be directed to a method for correcting the coplanarity of the tines 4c of the contacts 4 structured in the manner as described above. A situation requiring correction of the position of the tine 4c, i.e., the height of the tine 4c from the substrate 100 means a case in which the housing 2 has deformed after forming, and a gap G which is greater than a predetermined value has developed, as illustrated in Figure 3. The gap G may be detected, for example, by monitoring the connector 1 from the rear side by a camera, and determining variations in the gap G on the image. When a correction is performed, a stick-like jig 60 is inserted from the opening 58 of the shell 10 to the tine 4c through the hole 44 of the contact 4 and opening 52 of the housing 2, and the soldering portion 40 is pressed downward, i.e., toward the substrate 100 by the jig 60. This forces the soldering portion 40 to be displaced downward and the gap G falls within a predetermined range. Generally, the jig 60 has a bottom dead center set thereto to limit the traveling (moving distance) of the jig to a predetermined value, and attached to a machine. The correction of the tine 4c is completed by a single pressing operation of the jig 60. Thereafter, the appropriately positioned soldering portion 40 is soldered to the substrate 100.

In the present embodiment, the opening 52 of the housing 2 and hole 44 of the contact 4 for inserting the jig 60 have rectangular and circular shapes respectively, but they may have a polygonal shape, overall shape, and the like. Further, the opening 52 may have a notch shape, other than an opening with closed perimeter formed in the housing 2.

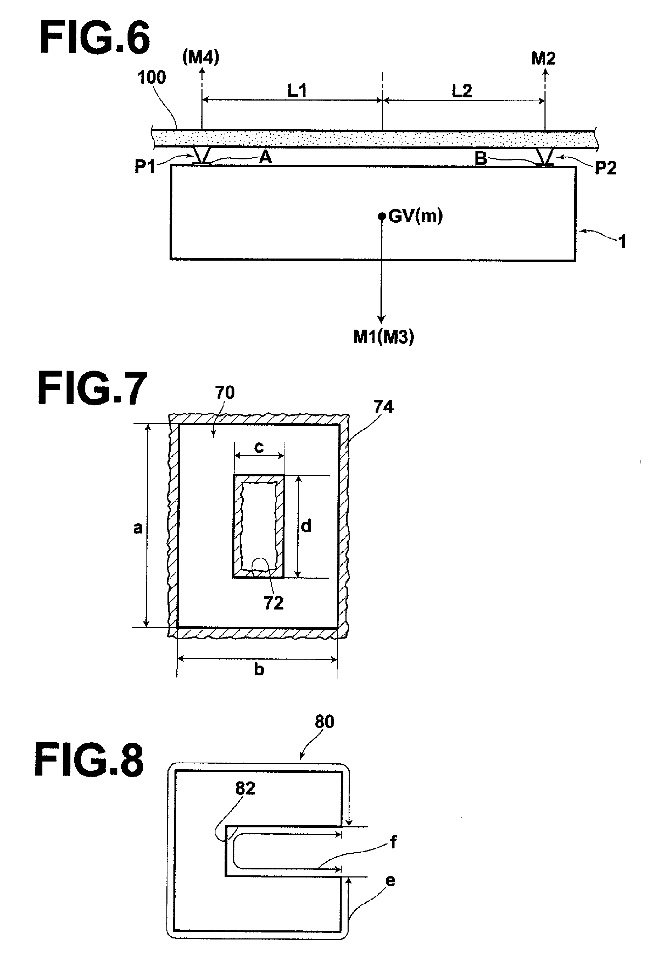

Next, the attachment of the connector 1 to the substrate 100 will be described with reference to Figure 6. Figure 6 is a conceptual diagram, schematically illustrating a state in which the substrate 100 with the surface mounted connector 1 is inverted for a second reflow soldering (reflow) (overall-heating soldering). In the second reflow, the solder of a fixing portion (first soldering portion) P1 and a fixing portion (second soldering portion) P2 is generally melted. The fixing portions P1, P2 are generally set at least at two places across the gravity center GV along the longitudinal direction. The rotational moment (moment) generated by the fixing points P1, P2 is as follows.

When the distances from the gravity center GV of the connector 1 to the fixing portions P1, P2 along the longitudinal direction of the substrate are assumed to be L1, L2 respectively, and the weight of the gravity center GV of the connector 1 is assumed to be m, the moment M1 around the fixing portion P1, clockwise (downward) in Figure 6, is expressed as $L1 \times m$. The moment M1 acts as a force that falls off the connector 1 from the substrate 100 against the surface tension of the melted solder of the fixing portion P2. In the mean time, the moment M2 produced by the surface tension having a direction (upward) which is opposite to the moment M1 at the fixing portion P2 is expressed as (L1 + L2) Bk, Where, B is the total circumferential length of the soldering portion, and k is a coefficient (empirical value).

The description will now be directed to the total circumferential length with reference to Figure 7. Figure 7 is a drawing schematically illustrating a rectangular soldering portion 70 as a specific shape of the fixing portions P1, P2 with an opening 72 in the center. The soldering portion 70 corresponds to the soldering portion 40 of the attachment piece 22 and electrical contact 4, and the opening 72 corresponds to the opening 22a of the attachment piece 22 and the opening 42 of the soldering portion 40. In Figure 7, a solder fillet 74 indicated by slashes is formed at the outer circumference of the soldering portion 70, and inner circumference thereof, i.e., inner circumference of the opening 72. The total length of the outer circumference is the sum of each side, i.e., calculated as $(a + b) \times 2$, and the total length of the inner circumference is calculated $(c + d) \times 2$, so that the total circumferential length B is calculated as $(a + b + c + d) \times 2$. In this case, the moment M2, which is a force that retains the connector 1 produced by the surface tension, is calculated as (L1 + L2)Bk. Here, note that the value of the coefficient k is 0.028. The condition for not falling off the connector 1 from the substrate 100 is $M1 \leq M2$. That is, the following formula will hold.

$$M1 \leq M2$$
$$M1 = L1 \times m, \quad M2 = (L1 + L2) \times Bk$$
$$L1 \times m \leq (L1 + L2) \times Bk$$
$$B \geq (L1 \times m)/(L1 + L2)k \qquad \text{(Formula 1)}$$

(where: L1 is the length from the gravity center to the first soldering portion along the circuit board (mm) ; L2 is the length from the gravity center to the second soldering portion along the circuit board (mm) ; m is the weight of a surface mount electrical component (g); k is the coefficient (0.028); and B is the total circumferential length of the second soldering portion (mm)).

That is, in the present embodiment, if, for example, the soldering portion 40 of the tine 4c is assumed to correspond to the fixing portion P2, the opening 42 of the soldering portion 40 corresponds to the opening 72 of the soldering portion 70. Accordingly, here, if the total circumferential length of the soldering portion 40 of the tine 4c is determined to satisfy $B \geq (L1 \times m)/(L1 + L2)k$, the connector 1 is prevented from falling off the substrate 100 at the fixing portion P2 or the tine 4c. In actuality, the connector 1 includes a plurality of contacts 4, and hence tines 4c located corresponding positions in the longitudinal direction. Therefore, the total sum B is calculated in consideration of the number of contacts 4.

In the mean time, the solder in the fixing portion P1 would also be melted, so that it is also necessary to take into account the moment with respect to the fixing point P2. In this case, a downward moment M3 caused by the gravity force at the gravity center GV of the connector 1 is calculated as $L2 \times m$. Assuming that the total circumferential length of the fixing portion P1 is A, a moment of the opposite direction (upward) M4 caused by the surface tension of the fixing portion P1 is calculated as $(L1 + L2) \times Ak$. The condition for not falling off the connector 1 from the substrate 100 is $M3 \leq M4$. That is, the following formula will hold.

$$M3 \leq M4$$

$$M3 = L2 \times m, \quad M4 = (L1 + L2) \times Ak$$

$$L2 \times m \leq (L1 + L2) \times Ak$$

$$A \geq (L2 \times m)/(L1 + L2)k \qquad \text{(Formula 2)}$$

(where, L1 is the length from the gravity center to the first soldering portion along the circuit board (mm) ; L2 is the length from the gravity center to the second soldering portion along the circuit board (mm) ; m is the weight of a surface mount electrical component (g); k is the coefficient (0.028); and A is the total circumferential length of the first soldering portion (mm)).

In the present embodiment, the fixing portion P1 may be the attachment piece 22 located opposite to the tine 4c across the gravity center GV. Thus, in this case, the opening 72 of the soldering portion 70 corresponds to the opening 22a of the attachment piece 22. Further, the connector 1 includes a pair of attachment pieces 22 located corresponding positions in the left/right direction, so that the total sum A is calculated in consideration of the number. If, for example, the soldering portions 70 are not located in left/right symmetrical positions, as do the attachment pieces 22, i.e., displaced in the longitudinal direction, the total sum may be calculated for each of them separately.

In actuality, in order to reliably prevent the connector 1 from falling off the substrate 100, it is necessary that both of Formulae 1 and 2 described above are satisfied.

So far an exemplary embodiment of the present invention has been described, but the present invention is not limited to this, and it will be obvious to those skilled in the art that various changes and modifications may be made without departing from the scope of the invention. For example, fixing portions P1, P2 may be deemed as the tine 4c and attachment piece 22 respectively or conversely as the attachment piece 22 and tine 4c respectively. Further, the shape of the soldering portion is not necessarily a shape having an opening with closed perimeter, and any shape may be employed as long as it may increase the circumferential length. For example, Figure 8 illustrates a soldering portion having another shape. The soldering portion 80 illustrated in Figure 8 has a notch 82, which may be employed as a shape of the soldering portion. In this case, the total circumferential length is the sum of the outer circumference e and inner circumference f. Of course, a circular or oval hole may also be used other than a notch.

## Claims

1. A surface mount electrical component including a plurality of soldering portions which is soldered on a surface of a circuit board, wherein:

   the total circumferential length of a second soldering portion, on which a solder fillet is formed, of the plurality of soldering portions is set such that, when the surface mount electrical component is on the underside of the circuit board, the relationship between a downward rotational moment M1 around a first soldering portion caused by the gravity force at the gravity center, and an upward rotational moment M2 acting on the second soldering portion produced by the surface tension of melted solder melded during overall-heating soldering is M1 ≤ M2; and the total circumferential length of the first soldering portion, on which a solder fillet is formed, located opposite to the second soldering portion across the gravity center of the surface mount electrical component is set such that, when the surface mount electrical component is on the underside of the circuit board, the relationship between a downward rotational moment M3 around the second soldering portion caused by the gravity force at the gravity center and an upward rotational moment M4 acting on the first soldering portion produced by the surface tension of melted solder melded during the overall-heating soldering is M3 ≤ M4.

2. The surface mount electrical component according to claim 1, wherein the total circumferential lengths A and B of the first and second soldering portions respectively, take values within the ranges obtained by the following formulae:

$$M1 = L1 \times m, \; M2 = (L1 + L2) \times Bk$$

$$L1 \times m \leq (L1 + L2) \times Bk$$

$$B \geq (L1 \times m)/(L1 + L2)k$$

$$M3 = L2 \times m, \; M4 = (L1 + L2) \times Ak$$

$$L2 \times m \leq (L1 + L2) \times Ak$$

$$A \geq (L2 \times m)/(L1 + L2)k$$

(where, L1 is the length from the gravity center to the first soldering portion along the circuit board; L2 is the length from the gravity center to the second soldering portion along the circuit board; m is the weight of the surface mount electrical component; k is a coefficient; A is the total circumferential length of the first soldering portion; and B is the total circumferential length of the second soldering portion).

**FIG.1A**

1

12
10
48  4  5  2d  8  14
10
2
10c
20a  22  2e  22  20b

**FIG.1B**

1

28a  32a  2d  32b  28b  3  32c
28
30a  30b  58  4  30c
10c

10b
10

2b  5  2c
5  2
3

22  22

6

**FIG.1C**

1

2  10  48
10c
10b
2d
4
20b  4  46  2e
20a

# FIG.2A

# FIG.2B

# FIG.2C

# FIG.3

# FIG.4

# FIG.5A

# FIG.5B

# FIG.6

# FIG.7

# FIG.8

## INTERNATIONAL SEARCH REPORT

| | International application No. |
|---|---|
| | PCT/JP2006/300317 |

| A. CLASSIFICATION OF SUBJECT MATTER |
|---|
| *H05K1/18*(2006.01), *H05K3/34*(2006.01) |

According to International Patent Classification (IPC) or to both national classification and IPC

| B. FIELDS SEARCHED |
|---|
| Minimum documentation searched (classification system followed by classification symbols) <br> *H05K1/18*(2006.01), *H05K3/34*(2006.01) |

Documentation searched other than minimum documentation to the extent that such documents are included in the fields searched

    Jitsuyo Shinan Koho     1922-1996   Jitsuyo Shinan Toroku Koho   1996-2006
    Kokai Jitsuyo Shinan Koho   1971-2006   Toroku Jitsuyo Shinan Koho   1994-2006

Electronic data base consulted during the international search (name of data base and, where practicable, search terms used)

| C. DOCUMENTS CONSIDERED TO BE RELEVANT | | |
|---|---|---|
| Category* | Citation of document, with indication, where appropriate, of the relevant passages | Relevant to claim No. |
| Y | JP 05-315738 A (Kabushiki Kaisha Seikosha), 26 November, 1993 (26.11.93), Par. No. [0006]; Fig. 11 (Family: none) | 1,2 |
| Y | JP 2000-357866 A (Lucent Technologies Inc.), 26 December, 2000 (26.12.00), Par. No. [0035] & US 6189203 B1 & EP 1043920 A2 | 1,2 |
| Y | JP 2003-115334 A (Tyco Electronics AMP Kabushiki Kaisha), 18 April, 2003 (18.04.03), Par. No. [0028]; Fig. 4 & US 2003/0068917 A1 | 1,2 |

☐ Further documents are listed in the continuation of Box C.     ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 06 April, 2006 (06.04.06) | 18 April, 2006 (18.04.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001358456 A
- JP 10256433 A
- JP 2003115334 A
- JP 10064608 A
- JP 2004207168 A